# EUROPEAN PATENT APPLICATION

(11) **EP 1 049 146 A2**
(43) Date of publication of application: **02.11.2000**
(21) Application number: 00303573.0
(22) Date of filing: 27.04.2000
(51) Int. Cl.: H01L 21/306, H01L 21/02, H01L 21/00

(54) **Method and apparatus for forming an inlaid capacitor in a semiconductor wafer**

(30) Priority: 30.04.1999 US 303020
(71) Applicant: Applied Materials, Inc., Santa Clara, California 95054 (US)
(72) Inventor: Amico, Gregory M., Fremont California 94539 (US); Davenport, Robert E., San Jose, California 95120 (US)
(74) Representative: Bayliss, Geoffrey Cyril

(57) **Abstract**

An inlaid capacitor and method of forming the same on a semiconductor wafer (10) provides for polishing a layer (18,20) formed within a cavity (16) and on a top surface of the semiconductor wafer. The layer may include a bottom electrode layer (20) of the capacitor. The cavity, which remains open since a sacrificial material is not used to protect the cavity during polishing, contains residual particles (22) after the polish process is completed. The particles are loosened from the surfaces of the bottom electrode layer by a megasonic cleaning process. In order to remove the loosened residual particles, the semiconductor wafer is subjected to a double-sided brush scrubbing. Following the removal of substantially all of the residual particles from within the cavity, and the surface of the bottom electrode layer, formation of the capacitor completed by the deposition of a dielectric material (24) and a top electrode layer (26).

## Description

The present invention relates to the field of forming structures in a semiconductor wafer, and more particularly, to the formation of inlaid capacitors or other structures having a cavity within a semiconductor wafer.

One of the continuous challenges in semiconductor memory fabrication is to provide sufficiently high storage capacitance despite decreasing cell areas. Three-dimensional cell capacitors, such as trenched (or inlaid) and stacked capacitors have been proposed. Stacked capacitors, and a method of making the same, are described in U.S. Patent No. 5,391,511. In that patent, a prior art method was described in which a three-dimensional structure of polysilicon is created. The structure contains an outwardly open cavity. In the prior art, the cavity is filled with a sacrificial material such as polyimide or photoresist. The purpose of the sacrificial material is to prevent slurry particles produced in a chemical-mechanical polishing (CMP) step that is subsequently performed from entering and remaining in the cavity. Once CMP slurry residual particles enter the cavity, it is often difficult to remove the residual particles completely. The method described in U.S. Patent 5,391,511 avoids the use of a sacrificial material in an attempt to reduce the manufacturing process by at least two steps: the deposition and subsequent removal of the sacrificial material within the cavity. This is accomplished by leaving the cavity open and performing a CMP polish for a time of between about 1 to 2 minutes. This process typically leaves a slurry residual, including SiO₂ grit, inside the cavity. The slurry residuals are then removed. The technique employed for removing the residuals is to first spray the wafer with a cleaning fluid under pressure, followed by megasonic cleaning of the wafer. Megasonic treatment time is described as being performed for five minutes at room temperature and pressure conditions. Further SiO₂ grit removal is facilitated by an HF dip (hydrofluoric acid dip), which also etches SiO₂.

Although U.S. Patent 5,391,511 describes an arrangement in which the use of a sacrificial material is avoided, there are some problems with this approach. One of these problems is the use of HF dip to facilitate the SiO₂ grit removal. The use of HF dip is undesirable since there are many safety issues and process complexities involved when HF is introduced into a facility. Another disadvantage of the disclosed method is the reduced throughput that results from moving the semiconductor wafer from the CMP machine to an HF dip.

Another concern is the applicability of such a procedure with a different type of capacitor structure, such as an inlaid capacitor. High capacitance values are achieved in the structure of U.S. Patent 5,391,511 by the raised three-dimensional physical structure of the capacitor. In order to achieve roughly the same capacitance values in an inlaid capacitor, different materials are used, which after a polishing back, produce residuals that are typically more difficult to remove than those produced in polishing back typical stacked structure capacitors.

There is a need for a method and apparatus for chemical-mechanical polishing a semiconductor wafer, and removing the residuals contained within a cavity in a semiconductor wafer in a manner that does not negatively impact throughput, avoids the use of highly toxic chemicals such as HF, and removes substantially all of the residual particles from cavities in the surface of the semiconductor wafer produced during the polishing.

This and other needs are met by embodiments of the present invention which provide a method of forming a structure on a semiconductor wafer in which a layer formed within a cavity and on the top surface of a semiconductor wafer is polished. The semiconductor wafer is then megasonically cleaned, followed by brush scrubbing of the semiconductor wafer.

One of the advantages of the present invention is the high throughput achieved by avoiding the steps involved in depositing a sacrificial material within a cavity to protect against residues forming within the cavity during polishing. The steps of depositing a sacrificial material, and then removing the material once the polishing is complete, have a very negative impact upon production throughput. However, the cavity is maintained in a residual-free state in the present invention by megasonically cleaning the semiconductor wafer and then brush scrubbing the semiconductor. The step of brush scrubbing the semiconductor wafer serves to remove residual particles from the cavity that were loosened by the megasonic cleaning of the semiconductor wafer. Hence, the use of an HF dip , with its attendant safety concerns and deleterious effect on throughput, is avoided.

The earlier stated needs are also met by another embodiment of the present invention which provides a method of forming an inlaid capacitor in a semiconductor wafer comprising the steps of forming a cavity in a substrate layer for the semiconductor wafer, and depositing at least one layer of a capacitor over a top surface of the substrate layer and in the cavity of the substrate layer. Polishing is then performed to remove the layer from the top surface of the substrate layer, this polishing creating residual particles in the cavity. The semiconductor wafer is megasonically cleaned to loosen the residual particles, and the residual particles within the cavity are then mechanically removed.

The earlier stated needs are met by another embodiment of the present invention. which provides an inlaid capacitor arrangement in a semiconductor wafer. The arrangement includes a substrate layer having a cavity formed therein. This cavity has an aspect ratio greater than about 1.5:1. A bottom electrode is formed within the cavity and has an upper surface substantially free of residual particles produced in a polishing process. A dielectric layer is formed within the cavity and a top electrode is formed on the dielectric layer. One of the advantages of the present invention is the relatively high aspect ratio of the inlaid capacitor arrangement, while still maintaining a cavity that is substantially free of residual particles.

One of the advantages of the inlaid capacitor arrangement of the present invention is the relatively high aspect ratio of the cavity of the inlaid capacitor. Despite the high aspect ratio, the cavity is free of residual particles produced in a polishing process.

The earlier stated needs are also met by another embodiment of the present invention which provides an arrangement for in-situ removal from a semiconductor wafer residual particles produced in a polishing process. The arrangement comprises a single machine that includes a megasonic cleaning station configured to loosen from the surface of the semiconductor wafer residual particles created during polishing of the semiconductor wafer. A brush scrubbing station is configured to remove loosened residual particles from the semiconductor wafer. A robotic transfer device automatically transfers semiconductor wafers from the megasonic clearing station to the brush scrubbing station.

One of the advantages of the arrangement of the present invention is the in-situ nature of the cleaning and scrubbing process. This speeds up the overall process and reduces human intervention in handling the wafer, by avoiding the carrying of a wafer by a human between a cleaning device and a scrubbing device. Also, the combination of a megasonic cleaning station followed by a brush scrubbing station throroughly removes residual particles (produced during CMP, for example) from trenches, even those with high aspects ratios. This allows elimination of a sacrificial oxide conventionally used to fill the trench to prevent CMP residual particles from entering and remaining in the trench.

Additional features and advantages of the present invention will become readily apparent to those skilled in the art from the following detailed descriptions, when embodiments of the invention are described, simply by way of illustration of the best mode contemplated for carrying out the invention. As will be realized, the invention is capable of other and different embodiments and its several details are capable of modifications and various obvious respects, all without departing from the invention. Accordingly, the drawings and description are to be regarded as illustrative in nature, and not as restrictive.

Figure 1 is a cross-section of a portion of a semiconductor wafer during one step of the process of forming an inlaid capacitor in accordance with an embodiment of the present invention.

Figure 2 is a cross-section of the portion of Figure 1 following the deposition of a barrier layer within the cavity formed in the semiconductor wafer.

Figure 3 depicts the portion of Figure 2 after the deposition of an electrode layer over the barrier layer.

Figure 4 depicts the portion of Figure 3 following the chemical-mechanical polishing of the electrode layer and the barrier layer in accordance with embodiments of the present invention.

Figure 5 depicts the portion of Figure 4 after megasonically cleaning the semiconductor wafer in accordance with embodiments of the present invention.

Figure 6 depicts the portion of Figure 5 after a double-sided brush scrubbing in accordance with embodiments of the present invention.

Figure 7 depicts the portion of Figure 6 after the deposition of a capacitor material layer in accordance with an embodiment of the present invention.

Figure 8 depicts a portion of Figure 7 after the formation of an upper electrode layer over the capacitor material layer in accordance with embodiments of the present invention.

Figure 9 depicts a block diagram of an apparatus for cleaning and scrubbing a semiconductor wafer in accordance with embodiments of the present invention.

The present invention addresses the problem of increasing production throughput when forming inlaid capacitors in a semiconductor wafer, but at the same time avoiding the safety risks and complexities of using dangerous chemicals, such as hydrofluoric acid dips. The invention achieves this in part by avoiding the use of a sacrificial material to fill the cavity of an inlaid capacitor during chemical-mechanical polishing. Since the cavity is open during the polishing, residual particles during the polishing, such as alumina, are created and temporarily remain within the cavity. These residual particles are removed in the present invention by a multiple step process in which the particles are first loosened by a megasonic cleaning of the semiconductor wafer. This cleaning is then followed by a double-sided brush scrubbing, in certain embodiments, to remove the residual particles loosened during the megasonic cleaning of the semiconductor wafer. This scrubbing mechanically removes the residual particles, which avoids the complexities and safety issues involved in employing hydrofluoric acid to remove the residual particles produced during the polishing.

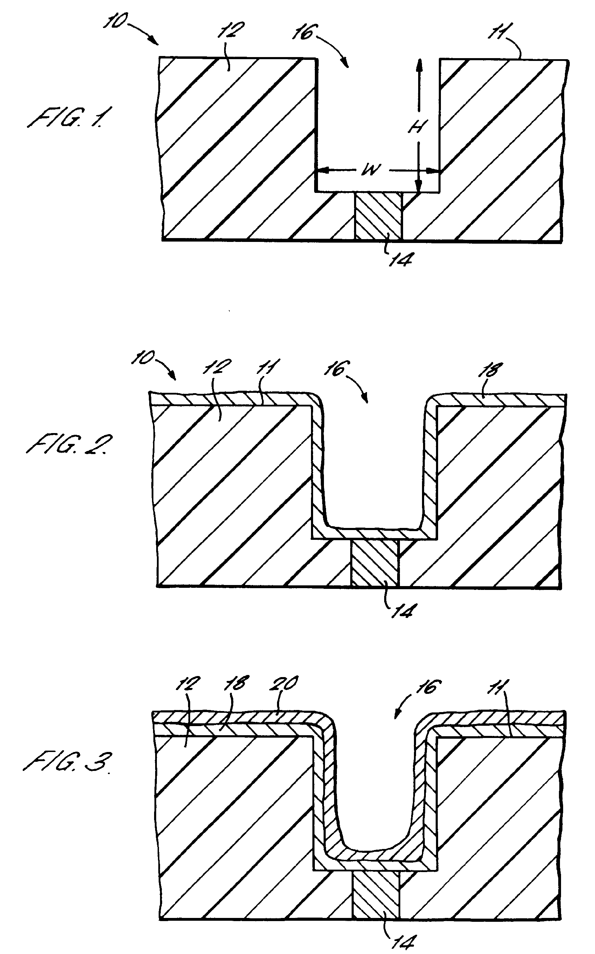

Figure 1 depicts a cross-section of a portion of a semiconductor wafer during the formation of an inlaid capacitor in accordance with embodiments of the present invention. The semiconductor wafer (generally referred to with reference numeral 10) has a substrate layer 12, formed from a dielectric material, for example. A cavity 16 has been formed in the substrate layer 12, for example by etching. The cavity 16 is located over a conductive material 14, such as a tungsten plug. The cavity 16 has an aspect ratio that is defined by the height H that is compared to the width W (H:W). The height H is measured from the top surface 11 of the substrate layer 12 to the top of the plug 14. The aspect ratio H:W may be varied in dependence upon the desired structure of the inlaid capacitor. One of the advantages of the present invention is that the aspect ratio may be made relatively high, e.g. greater than 1.5:1, while also providing adequate cleaning of the residual particles from the cavity 16. The aspect ratio may range between wide aspect ratios (less than 1:1) to aspect ratios between 1.5:1 to 15:1. Adequate cleaning of residual particles can be expected in cavities with aspect ratios up to 15:1.

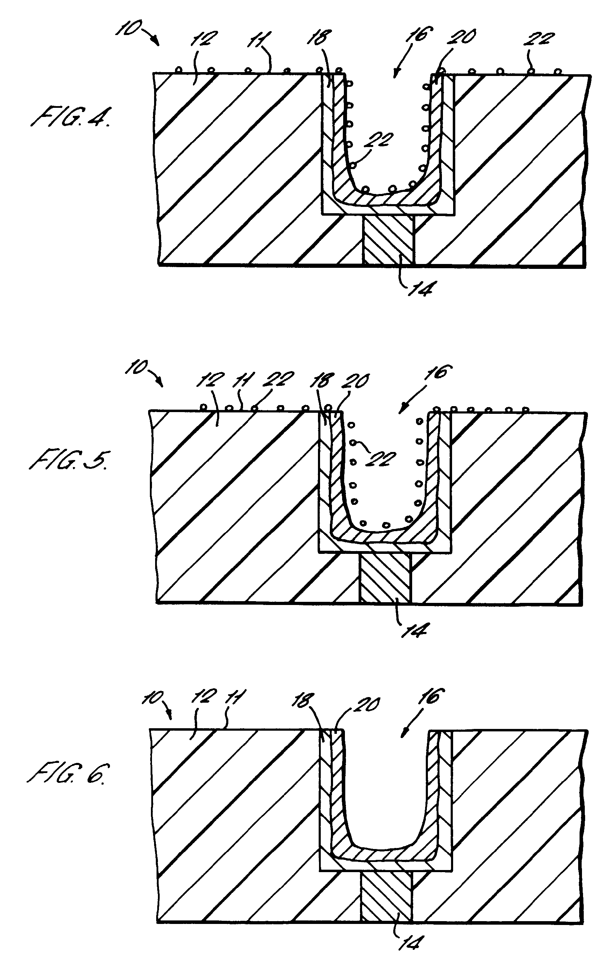

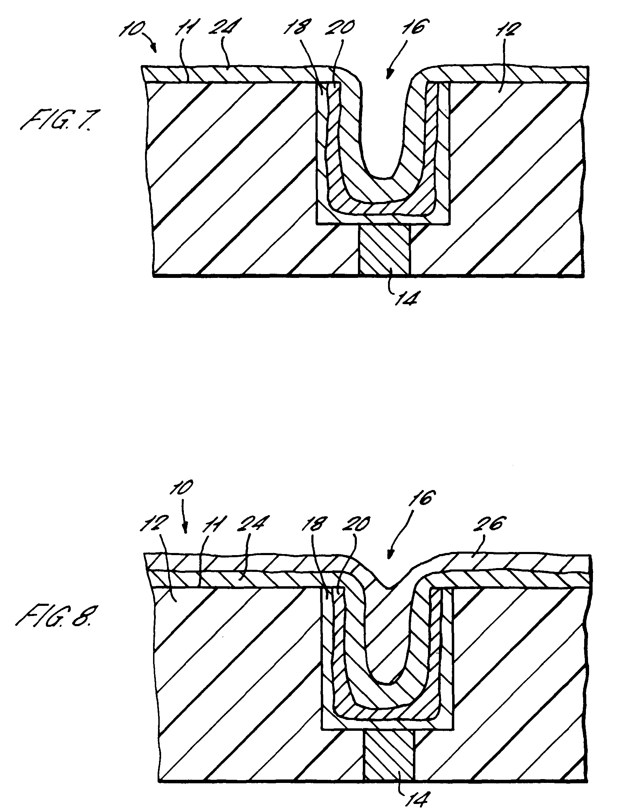

In Figure 2, the portion of semiconductor 10 is depicted after the deposition of a barrier layer 18 over the surface 11 of the substrate layer 12 and within the cavity 16 of the substrate layer 12. The barrier layer may comprise titanium nitride (TiN), for example. Another example of a material suitable for use as a barrier layer 18 is tungsten nitride (WN). Following the deposition of the barrier layer 18, a bottom electrode layer 20 is formed by deposition, for example, conformably over the barrier layer 18 (Figure 3). Examples of materials suitable for use as the bottom electrode layer 20 are polysilicon, plantinum (Pt), ruthenium (Ru) and iridium (Ir). Other materials may be used in the bottom electrode layer 20, as may be appropriate for different performance characteristics desired for the capacitor.

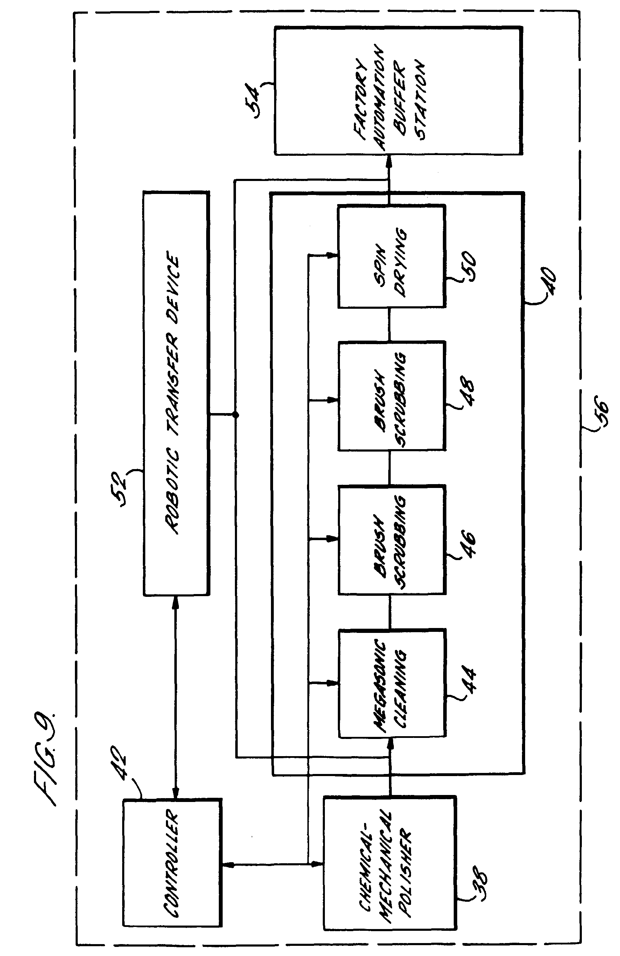

Figure 4 depicts the portion of the semiconductor wafer 10 following a polishing step. The polishing is a chemical-mechanical polishing, in preferred embodiments of the present invention. The slurry used may be an alumina-based slurry or a silica-based slurry, or any other suitable slurry for polishing the barrier layer 18 and bottom electrode layer 20. The selection of the slurry that is used in polishing will depend upon the materials being polished. As can be seen in Figure 4, the polishing is performed until the bottom electrode layer 20 and barrier layer 18 are removed from the top surface 11 of the substrate layer 12. The top surface 11 of the substrate layer 12 is thereby exposed. Residual particles 22, such as alumina particles, are created during the polishing of the layers 18, 20. The residual particles 22 are located within the cavity 16 and on the top surface 11 of the substrate layer 12. It is desirable to remove these residual particles 22 prior to the formation of the rest of the capacitor structure to ensure proper performance of the capacitor.

Figure 5 depicts the portion of semiconductor 10 following megasonic cleaning of the semiconductor wafer 10. The megasonic treatment time may be selected by the process engineer in accordance with varying requirements. However, a cleaning time of approximately 30 seconds for a single wafer is advantageous in that it serves to loosen the residual particles 22 from the surface of the bottom electrode layer 20 and the top surface 11 of the substrate layer 12. Complete removal of the residual particles 22 is not sought during this megasonic cleaning step. Because of the relatively short application of megasonic cleaning to the semiconductor 10, the throughput is not significantly impacted as would be the case of employing a sacrificial material and removing that material to protect the cavity. Also, a relatively short megasonic cleaning time of approximately 30 seconds is an improvement over other capacitor forming processes in which megasonic cleaning is applied for five minutes (see U.S. Patent 5,391,511 for example).

With the residual particles 22 loosened from the surfaces of the bottom electrode layer 20 and the top surface 11 of the substrate layer 12, the residual particles may be readily removed mechanically by double-sided brush scrubbing, for example. Such double-sided brush scrubbing is a well-known technique for cleaning wafers. The brush scrubbing may be applied for between 30 seconds to 5 minutes, with less than 45 seconds being a preferred length of time adequate to remove the particles. The resultant structure is depicted in Figure 6, and can be seen to now be free of residual particles 22. The structure is then ready for completion of the formation of the inlaid capacitor.

Figure 7 depicts the portion of semiconductor wafer 10 of Figure 6 after a high, k dielectric material 24 is deposited within the cavity 16 and over the top surface 11 of the substrate layer 12. Exemplary materials for the high k dielectric layer 24 include BST, PZT, or Ta₂O₅.

The capacitor structure is completed by the formation of an upper electrode layer 26 over the capacitor material 24 (Figure 8). The upper electrode layer 26 may be made of any suitable material, such as platinum (Pt) ruthenium (Ru) or indium (Ir).

Figure 9 is a block diagram depicting certain components of an arrangement 56 to perform the methods described above in an in-situ manner. Semiconductor wafers, after chemical-mechanical polishing by a chemical mechanical polisher 38, enter the cleaning system 40 through an input. The first station in the cleaning system 40 is a megasonic cleaning station 44, operated in accordance with the parameters described earlier. After the megasonic cleaning, wafers are transferred automatically by a robotic transfer device 52 to a first brush scrubbing station 46 that performs a brush scrubbing, as described earlier. Wafers are then transferred to a second brush scrubbing station 48, provided in preferred embodiments of the invention. From the second brush scrubbing station 48, the wafers are transferred by the robotic transfer device 52 to a spin drying station 54. The wafers are dried and output from the cleaning system 40. Control of the stations 44-50 and the robotic transfer device 52 is performed by a computer controller 42. A factory automation buffer station 54 provides loading and unloading of dry wafers to the arrangement 56. This makes the arrangement 56 a dry-in, dry-out arrangement.

One of the advantages of the present invention is that the CMP, megasonic cleaning and brush scrubbing may all be performed in a single machine ("in-situ"). In addition to increasing throughput by reducing the processing time required to move the wafers from machine to machine, the arrangement of the invention reduces the risk of damage to the wafers, since they are automatically transferred from station to station within the single machine.

The present invention as described above provides an inlaid capacitor, which is substantially free of residual particles created during a polishing step, without the use of sacrificial materials to fill a cavity during the polishing step. The combination of megasonic cleaning and brush scrubbing loosens and removes the residual particles created during the polishing, allowing the elimination of steps for deposition and removal of the sacrificial material within the cavity. This has the advantage of increasing the throughput during the manufacturing the semiconductor devices. At the same time, use of dangerous dips to remove residual particles is avoided by employing brush scrubbing techniques.

Although the present invention has been described and illustrated in detail, it is to be early understood that the same is by way of illustration and example only and is not be taken by way of limitation, the spirit and scope of the present invention being limited only by the terms of the appended claims.

## Claims

1. A method of processing a semiconductor wafer, comprising the steps of:
forming a layer within a cavity and on a top surface of a semiconductor wafer;
polishing the top surface of the semiconductor wafer,
megasonically cleaning the semiconductor wafer; and
brush scrubbing the semiconductor wafer including the cavity.

2. A method as claimed in claim 1, wherein the step of polishing includes chemical-mechanically polishing the layer on the top surface, thereby producing residuals within the cavity.

3. A method as claimed in claim 2, wherein the step of megasonically cleaning includes loosening from surfaces of the semiconductor wafer residual particles produced during the polishing.

4. A method as claimed in any of claims 1 to 3, wherein the step of brush scrubbing includes removing loosened residual particles from the surfaces of the semiconductor wafer.

5. A method as claimed in any of claims 1 to 4, wherein the step of megasonically cleaning includes subjecting the semiconductor wafer to a cleaning solution comprising at least one or more of: deionised water, ammonia, ammonia hydroxide peroxide and citric acid.

6. A method as claimed in any of claims 1 to 5, wherein the step of megasonically cleaning includes subjecting the semiconductor wafer to megasonic cleaning for a period of between about 30 and about 60 seconds.

7. A method as claimed in any of claims 1 to 6, wherein the step of brush scrubbing the semiconductor wafer includes brush scrubbing the semiconductor wafer for a period of between about 30 and about 60 seconds.

8. A method of forming an inlaid capacitor in a semiconductor wafer, comprising the steps of:
forming a cavity in a substrate layer of a semiconductor wafer;
depositing at least one layer of a capacitor over a top surface of the substrate layer and in the cavity of the substrate layer;
polishing to remove the at least one layer from the top surface of the substrate layer, the polishing creating residual particles within the cavity;
megasonically cleaning the semiconductor wafer to loosen the residual particles; and
mechanically removing the residual particles within the cavity.

9. A method as claimed in claim 8, wherein the step of mechanically removing includes brush scrubbing the semiconductor wafer.

10. A method as claimed in claim 8 or claim 9, wherein the step of polishing includes chemical-mechanical polishing.

11. A method as claimed in any one of claims 8 to 10, wherein the cavity formed has an aspect ratio greater than 1:1 and the step of mechanically removing removes substantially all of the residual particles within the cavity.

12. A method as claimed in claim 11, wherein the cavity formed has an aspect ration between about 2:1 and about 15:1, and the step of mechanically removing removes substantially all of the residual particles within the cavity.

13. A method as claimed in claim 12, wherein the cavity formed has an aspect ratio between about 5:1 and about 10:1, and the step of mechanically removing removes substantially all of the residual particles within the cavity.

14. A method as claimed in any one of claims 8 to 13, wherein one of the deposited layers is a barrier layer, and another one of the deposited layers is an electrode layer.

15. A method as claimed in claim 14, wherein the electrode layer comprises polysilicon.

16. A method as claimed in claim 15, wherein the step of polishing includes chemical-mechanical polishing the semiconductor wafer with at least one of an alumina-based slurry and a silica-based slurry.

17. A method as claimed in any one of claims 8 to 16, wherein the step of megasonically cleaning includes subjecting the semiconductor wafer to megasonic cleaning for a period of between about 30 and about 60 seconds.

18. An inlaid capacitor arrangement in a semiconductor wafer, comprising:
a substrate layer having a capacity formed therein, the cavity having an aspect ratio greater than about 1.5:1;
a bottom electrode formed within the cavity and having an upper surface substantially free of residual particles produced in a polishing process;
a dielectric layer formed within the cavity; and
a top electrode formed on the dielectric layer.

19. An arrangement as claimed in claim 18, further comprising a barrier layer in the cavity between the substrate layer and the bottom electrode.

20. An arrangement as claimed in claim 18 or claim 19, wherein the bottom electrode layer comprises at least one or polysilicon, platinum, ruthenium, or iridium.

21. An arrangement as claimed in any one of claims 8 to 20, wherein the dielectric layer comprises at least one of BST, PZT, Ta₂0₅.

22. An arrangement as claimed in any one of claims 8 to 21, wherein the top electrode layer comprises at least one of platinum, ruthenium or iridium.

23. An arrangement for in-situ removal from a semiconductor wafer residual particles produced in a polishing process, comprising:
a single machine that includes:
a megasonic cleaning station configured to loosen from the surface of the semiconductor wafer residual particles created during polishing of the semiconductor wafer;
a brush scrubbing station configured to remove loosened residual particles from the semiconductor wafer; and
a robotic transfer device to automatically transfer semiconductor wafers from the megasonic cleaning station to the brush scrubbing station.
